# EUROPEAN PATENT SPECIFICATION

(11) **EP 2 568 059 B1**
(45) Date of publication and mention of the grant of the patent: **06.07.2016**
(21) Application number: 11777486.9
(22) Date of filing: 06.05.2011
(51) Int. Cl.: C23C 14/06, G02B 7/02, G03B 17/14, C23C 14/32, C23C 14/54, H01B 1/22, H01B 1/24

(54) **MEMBER FORMED FROM CONDUCTIVE SLIDING FILM**
AUS EINEM LEITFÄHIGEN GLEITFILM GEFORMTES ELEMENT
ÉLÉMENT FORMÉ À PARTIR D'UN FILM CONDUCTEUR COULISSANT

(30) Priority: 07.05.2010 JP 2010106928
(43) Date of publication of application: 13.03.2013
(73) Proprietor: Nikon Corporation, Tokyo 108-6290 (JP)
(72) Inventor: TAKI, Yusuke, Tokyo 100-8331 (JP)
(74) Representative: Hoffmann Eitle
(86) International application number: PCT/JP2011/060609
(87) International publication number: WO 2011/138967

(56) References cited:
- EP-A1- 0 579 983
- JP-A- 6 212 429
- JP-A- 8 136 991
- JP-A- 2002 544 380
- JP-A- 2006 225 686
- JP-A- 2006 225 686
- JP-A- 2009 504 919
- US-A1- 2010 060 777
- LIN Y H ET AL: "Annealing effect on the structural, mechanical and electrical properties of titanium-doped diamond-like carbon films", THIN SOLID FILMS, ELSEVIER-SEQUOIA S.A. LAUSANNE, CH, vol. 518, no. 5, 31 December 2009 (2009-12-31), pages 1503-1507, XP026764001, ISSN: 0040-6090, DOI: 10.1016/J.TSF.2009.09.096 [retrieved on 2009-10-03]
- TAY B K ET AL: "On the properties of nanocomposite amorphous carbon films prepared by off-plane double bend filtered cathodic vacuum arc", THIN SOLID FILMS, ELSEVIER-SEQUOIA S.A. LAUSANNE, CH, vol. 420-421, 2 December 2002 (2002-12-02) , pages 177-184, XP004397841, ISSN: 0040-6090, DOI: 10.1016/S0040-6090(02)00795-2
- ZHANG P ET AL: "Surface energy of metal containing amorphous carbon films deposited by filtered cathodic vacuum arc", DIAMOND AND RELATED MATERIALS, ELSEVIER SCIENCE PUBLISHERS, AMSTERDAM, NL, vol. 13, no. 3, 10 January 2004 (2004-01-10), pages 459-464, XP004498789, ISSN: 0925-9635, DOI: 10.1016/J.DIAMOND.2003.11.083

## Description

### TECHNICAL FIELD

The present invention relates to a mount member comprising a conductive sliding film which can be formed on a surface of a member which is movable slidably and relatively (relative to other member), a camera body, a lens unit and a use of a sliding film in a mount member.

### BACKGROUND ART

With respect to a member which is movable slidably relative to other member and a member (referred to as "connection member") which is movable slidably on and relative to a contact surface of another member and is connectable to the contact surface, there exists a large number of members each having a coating film formed on a surface thereof. Such a member is exemplified by a packaging (exterior) material for an optical device, etc., and such a connection member is exemplified by a connection member referred to as a bayonet-type mount (hereinafter referred to simply as "mount") provided on a body side and a lens side in a camera system configured so that a lens unit is detachable (removable) and interchangeable with respect to a camera body. Such a mount is generally constructed of a substrate made of brass and a protective coating film which has conductivity (which is conductive) and which is made of metal chrome and formed on a surface of the brass substrate (see, for example, Patent Literature 1).

The reason that the metal chrome has been selected as a material for a surface processing (treatment) material for the mount is that the metal chrome is a metal which has a high reflectance with a beautiful metallic luster, which is relatively hard, which has the conductivity, and which can be produced with a relatively low production cost because of not being a rare metal. Namely, a mount in which a body-side mount and a lens-side mount are moved slidably and relative to each other so that the mounts are engaged with and connected to each other is required to have not only the sliding performance (slidability) or slidable moving performance (low friction coefficient) and the wear resistance (surface hardness), but also required to have the conductivity in order that the camera body and the lens unit have the same ground potential and/or that the mount is used as a signal current channel allowing the electricity to be passed between the camera body and lens unit. In addition, the mount is required to have beautiful metallic luster and corrosion resistance so as to ensure external appearance quality. In particular, the slidability (low friction coefficient) and the wear resistance (surface hardness) are correlative, and thus each of the slidability (low friction coefficient) and the wear resistance (surface hardness) needs to be adjusted to have a value in an appropriate range. For example, in a case that the surface hardness of the mount is too high, the friction coefficient becomes high, thus lowering the operability when attaching the lens unit to the camera body. On the other hand, in a case that the mount does not have a predetermined surface hardness, the surface processing or treatment (film) is damaged and/or is easily exfoliated or peeled off. Accordingly, the friction coefficient and the surface hardness are each required to have a value such that, when the lens unit is attached/detached with respect to the camera body, the mount can endure the attachment/detachment for a predetermined number of times, while maintaining a satisfactory operability. As described above, a camera mount is directly touched and operated by a user and is also a product in which user preference should be taken into consideration. Therefore, the camera mount is required to have characteristics which are not required for a sliding component of an automobile and/or for a machine for which only the operation performance and/or function is/are important.

If a material such as a metallic compound which is hard but has low reflectance is used instead of the metal chrome, it is not possible to obtain a desired external appearance quality. On the other hand, if a metal which has a high reflectance but is soft is used, there is a fear that any flaw might be generated after performing the lens exchange only for a small number of times, which in turn easily lower the external appearance quality, and further that the wear might progress to such an extent that the lens cannot be fixed at an accurate position, as well. The conventional technique to apply metal chrome plating on a surface of the brass substrate has been used as a technique to realize the above-described requirements in a relatively well-balanced manner.

### [CITATION LIST]

### [PATENT LITERATURE]

Patent Literature 1: Japanese Patent Application Laid-open No. 2006-225686
Patent Literature 2: Japanese Patent Application Laid-open No. H06-212429
Patent Literature 3: Japanese Patent Application Laid-open No. 2008-297477

### SUMMARY OF THE INVENTION

### Problem to be Solved by the Invention:

However, even in the conventional mount using the metal chrome coating film, there is a problem such that a layer of metal chrome is worn by a repeated exchange of the lens by the user, thus exposing the brass in the back layer, any damage such as a flaw (scar) is generated, etc., in some cases, and that the surface hardness and/or the durability are/is not necessarily sufficient.

Further, in view of the increased severity of the environmental problem, it has become a social mission to avoid any wet-type plating process using hexavalent chromium that is a hazardous chemical substance to human body; and there is desired a new film-forming technique capable of satisfying a predetermined requirement with a dry process.

As a coating material for a sliding material (slidably moving material), there is known a film of hard carbon having wear resistance and low-frictional/sliding properties. For example, Patent Literature 2 discloses a method for forming a film of hard carbon from methane gas with the plasma-enhanced CVD method, the sputtering method or the ion plating method while using an impurity element such as Ti and/or Mo, for the purpose of providing a film of hard carbon which has both of excellent wear resistance and high conductivity. Although Patent Literature 2 does not disclose the structure of the obtained film of hard carbon, it is appreciated, from the results of the experiments performed by the present inventor (to be described later on), that the obtained film of hard carbon in Patent Literature 2 has a structure close to that of a diamond-like carbon mainly comprised of sp² bond (hybrid orbital) or has a structure mainly composed of sp³ bond (hybrid orbital) containing a large amount of hydrogen.

In a case of the carbon film of the sp³ bond containing a large amount of hydrogen, however, there are a problem associated with the corrosion resistance, and such a problem that the adhesiveness of the carbon film is lowered since hydrogen is vaporized under high-temperature atmosphere. Further, the diamond-like carbon mainly composed of sp² bond is not suitable for the application to the camera mount in view of the wear resistance and the hardness.

In the recent years, there is known a technique of producing a low-friction sliding member from tetrahedral amorphous carbon (ta-C) which does not contain hydrogen and contains the sp³ bond in a relatively greater extent with respect to the sp² bond, by using the Filtered Cathodic Vacuum Arc method (FCVA method) (Patent Literature 3).

The present invention is made in view of such a situation, an object of which is to provide a conductive sliding film for a connection member which is suitable in particular for surface treatment (processing) for a camera mount, which has high wear resistance and satisfactory slidability and which has conductivity to enable transmission of electric signal, and a connection member having the conductive sliding film formed therein; and to provide a method capable of producing such a connection member with a dry process. Further, another object of the present invention is to provide a member such as a camera mount, a camera body and a lens unit each provided with such a conductive sliding film and such a connection member.

### Means for Solving the Problem:

According to a first aspect, there is provided a mount member as defined in claim 1 which contains a conductive sliding film which is applied on a surface of a member moving slidably relative to other member, the conductive sliding film being formed of tetrahedral amorphous carbon which is doped with a metal, wherein resistivity of the conductive sliding film is in a range of 10² to 10⁻⁴ [Ωcm], the surface hardness is 10 to 30 [GPa] and the dynamic friction coefficient is less than 0.15.

In this aspect, the metal for doping is titanium; and a content (content ratio) of the titanium may be 1 to 33 [at%], in particular, may be 1 to 20 [at%].

The member may be a member having the conductive sliding film of the first aspect formed on a connection surface of the member, the connection surface being movable slidably relative to and connectable to a connection surface of the other member. The member may be comprised of a substrate made of a metal material and the above-described conductive sliding film formed on a surface of the substrate.

The member may be at least one of a first connection member and a second connection member which move slidably relative to each other and are connected to each other, wherein when a connection surface of the first connection member and a connection surface of the second connection member move slidably relative to reach other and are engaged with and connected to each other, the first and second connection members may be mechanically connected and electrically connected.

There is also provided a mount member used for a camera system and provided on a side of a body and/or a lens of the camera system configured so that a lens unit is detachable and interchangeable with respect to a camera body, the mount member including: a substrate; and a conductive sliding film which is formed on the substrate; wherein the conductive sliding film is formed of tetrahedral amorphous carbon doped with a metal and which has resistivity of 10⁻² to 10⁻⁴ [Ωcm], surface hardness of 10 to 30 [Gpa] and dynamic friction coefficient of less than 0.15.

According to a fourth aspect, there is provided a camera body provided with the mount member for camera of the third aspect.

According to a fifth aspect, there is provided a lens unit provided with the mount member for camera of the third aspect.

According to a sixth aspect, there is provided a method for producing a conductive sliding film, the method including: arranging a member, which moves slidably relative to other member, in a vacuum chamber; and forming, on a surface of the member, a film of metal-doped tetrahedral amorphous carbon (ta-C:M) having resistivity in a range of 10² to 10⁻⁴ [Ωcm] and surface hardness in a range of 10 to 30 [GPa] with Filtered Cathodic Vacuum Arc method (hereinafter referred to as "FCVD" method, as appropriate) by using, as a raw material, a graphite target in which a metal or a metal carbide is contained. It is preferable that the target substantially does not contain hydrogen. Note that in the present application, the FCVA method encompasses not only a FCVA method in a narrow sense but also a cathodic vacuum arc method or vacuum arc method having a function (filter function) which classifies elements such as a specific ionized carbon, etc., and a method similar to the cathodic vacuum arc method or the vacuum arc method, for example, Arc Ion Plating method (AIP method).

### Effect of the Invention

According to the aspects as described above, it is possible to provide a conductive sliding film and a member each having a high wear resistance, a satisfactory slidability and a conductivity capable of electric signal transmission, in particular, a member suitable for a camera mount. In addition, such a member is produced by the FCVA method, without using any plating method, and thus causing any environmental problem.

### BRIEF DESCRIPTION OF THE DRAWINGS

Fig. 1 is a photograph of a titanium-doped tetrahedral amorphous carbon (ta-C:Ti) formed as a film on a silica glass substrate.
Fig. 2 is a phase diagram (ternary diagram) of carbon-hydrogen composition.
Fig. 3 is a schematic view showing the construction of a FCVA film-forming apparatus.
Fig. 4 is a schematic view of a camera system including an interchangeable lens which is attachable/detachable with respect to a camera body.
Fig. 5(a) is a plan view of a bayonet-type mount disposed on a side of the camera body as shown in Fig. 4; and Fig. 5(b) is a plan view of a bayonet-type mount disposed on a side of the interchangeable lens as shown in Fig. 4.
Fig. 6 is a schematic cross-sectional view of a surface of a mount in which a sliding film is formed on a substrate.
Fig. 7 is a table showing film-forming conditions and compositions of films formed in examples and comparative examples.
Fig. 8 is a table showing physical properties of the films formed in the examples and comparative examples.
Fig. 9 is a graph showing chemical composition of a ta-C:Ti film, formed on a silicon substrate, with respect to the depth of the ta-C:Ti film.
Fig. 10 is a graph showing a change in dynamic friction coefficients of ta-C:Ti film and ta-C film.
Fig. 11 is a table showing physical properties and attachment/detachment durability in Examples 6, 9-14 and Comparative Example 5.

### EMBOIDMENTS FOR CARRYING OUT THE INVENTION

Embodiments of the present invention will be explained below with reference to the drawings.

### [Tetrahedral amorphous carbon]

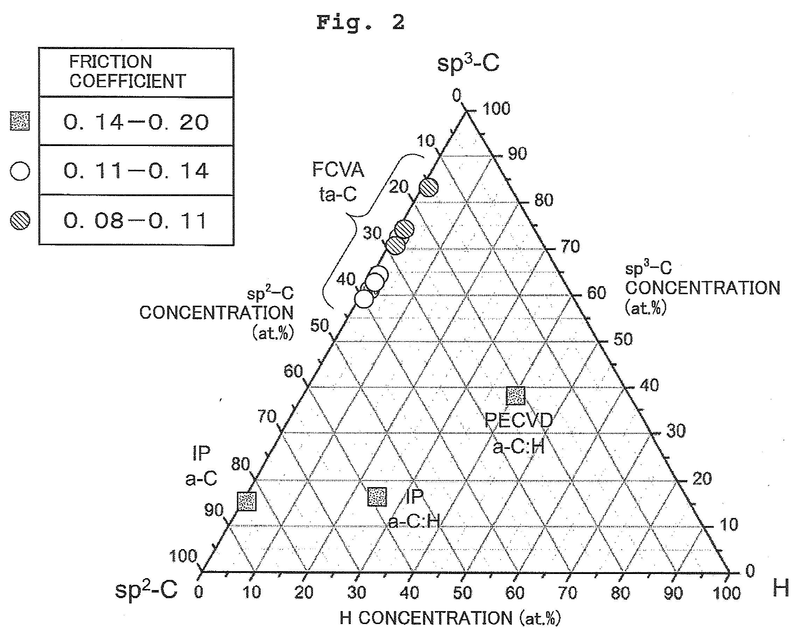

An explanation will be given about tetrahedral amorphous carbon which is used in the present invention. Fig. 2 shows a phase diagram (ternary diagram) of carbon-hydrogen composition of three components (ternary system) which are carbon composed of sp³ bond (sp³-C), carbon composed of sp² bond (sp²-C), and H (hydrogen). In Fig. 2, the numerical values added to respective sides of the triangle are as follows: the base: composition ratio of hydrogen H; the right side: composition ratio (concentration) of sp³-C; and the left side: composition ratio (concentration) of sp²-C. Further, the reference symbol "PECVD" means a plasma-enhanced CVD method using methane as the raw material, the reference symbol "IP" means an ion plating method using benzene as the raw material; and carbon-hydrogen compositions produced by these methods are indicated by squares in the drawing.

In this phase diagram, each of the apexes in the triangle is a pure single element (and bond) substance, wherein the sp³-bonded carbon sp³-C positioned in the upper apex is diamond; the sp²-bonded carbon sp²-C positioned in the lower left apex is graphite (black lead); and H positioned in the lower right apex is hydrogen. The sp³-C diamond and the sp²-C graphite are both composed of carbon as the composition element, but are clearly different from each other in the crystalline structure due to the difference in inter-atomic bond state.

Compounds on the respective sides in the triangle, except for those at the apexes, are each amorphous of two-component (binary) system; and on the left side connecting the upper apex (sp³-C) and the lower left apex (sp²-C), carbon compounds in which sp³-C and sp²-C are mixed randomly in a composition ratio based on a position thereof on the axis (the left side) are formed. Each of the carbon compounds which does not contain hydrogen is referred to as "amorphous carbon" and indicated as "a-C".

Among the amorphous carbons a-C, a carbon compound with a high composition ratio of sp³-C (approximately 50 to 90 %) is particularly referred to as "tetrahedral amorphous carbon" and indicated as "ta-C". Tetrahedral amorphous carbon does not substantially contain hydrogen, and is composed of sp³-C and sp²-C. The phrase that "does not substantially contain hydrogen" means that containing hydrogen only in an amount smaller than a detected amount of hydrogen originated from a measurement device (for example, not more than 0.3 at%). When attempt is made to measure the composition of an amorphous carbon film, hydrogen originated from a measurement device (for example, hydrogen adhered to the measurement device), as the background, is detected in some cases. In such a case, it is considered that the hydrogen is not substantially contained. Such a tetrahedral amorphous carbon can be produced by the FCVA method, but cannot be produced by the conventional CVD method.

Carbon-hydrogen compounds of the ternary system in which sp³-C, sp²-C and hydrogen are randomly mixed, respectively, are formed in an area inside the triangle surrounded by the three sides. The carbon compounds containing hydrogen as described above are referred to as "hydrogenated amorphous carbon", and indicated as "a-C:H". Among the a-C:H hydrogenated amorphous carbons, a carbon-hydrogen compound with a high composition ratio of sp³-C (in an upper inner area in the triangle in the phase diagram) is referred to as "hydrogenated tetrahedral amorphous carbon", and is indicated as "ta-C:H". Since ta-C:H contains hydrogen, it is known that ta-C:H has slidability (friction coefficient) needed for a sliding material inferior to that of ta-C which does not contain hydrogen. Further, it is known that ta-C:H has inferior hardness and heat resistance than those of ta-C.

As are well known, the diamond as sp³-C has such characteristics as extremely high hardness, transparent in the visible light range, and electrically insulating. On the other hand, the graphite as sp²-C has such characteristics as being soft, opaque (black color) in the visible light range, and self-lubricating (has low friction coefficient). Namely, the diamond (sp³-C) and the graphite (sp²-C) have mutually contrastive characteristics, although both being carbon compounds.

In the phase diagram, amorphous carbon a-C located on the line connecting sp³-C (diamond) and sp²-C (graphite) has an intermediate characteristic or property having both the characteristics of diamond and the characteristics of graphite, either of which being more dominant depending on the composition ratio thereof. Accordingly, it is assumed that a film of tetrahedral amorphous carbon ta-C containing a large amount of sp³-C may have wear resistance based on the high hardness, and may obtain satisfactory slidability based on the low friction coefficient. For a reference purpose, Fig. 2 shows the ranges of friction coefficients of amorphous carbons formed by the PECVD method, the IP method and the FCVA methods, respectively. Even with respect to the tetrahedral amorphous carbons formed by the FCVA method, it is appreciated that the friction coefficient is lower as the composition ratio of sp³-C becomes higher.

Provided that even it is possible to obtain the wear resistance and satisfactory slidability with the amorphous carbon a-C by combining the characteristics of both of the sp³-C and sp²-C, it has been considered to be impossible to impart the conductivity so as to enable transmission/receipt of electric signals such realized by the metal chrome; further, it has been also considered as being difficult to obtain a desired metallic external appearance by an a-C film for the following reasons. Namely, the reason of the extremely high hardness of diamond is realized by the covalent bond between carbon atoms not having any free electrons, whereas the conductivity and metallic luster are realized by having a large number of free electrons. The present invention has successfully produced a sliding film provided with a satisfactory wear resistance, slidability and conductivity by doping in particular tetrahedral amorphous carbon, among such amorphous carbons a-C as described above, with a metal.

### [Metal for doping]

A metal with which tetrahedral amorphous carbon is doped is exemplified by Ti, Ni, Cr, Al, Mg, Cu, Fe, Ag, Au, Pt, etc., in view of the wear resistance, slidability and conductivity, in particular the conductivity, of the sliding film. Among these metals, Ti, Cr, Ni, Fe are preferable. The content (dope amount) of metal in the sliding film is preferably 1 at% to 33 at%, in particular preferably 1 at% to 20 at%, in order to appropriately maintain the wear resistance, slidability and conductivity of the sliding film. In a case that the content is less than 1 at%, the conductivity is not sufficient and the electric resistance of the sliding film becomes high. In a case that the content exceeds 20 at%, the hardness of the sliding film tends to be lowered, which in turn deteriorates the wear resistance.

### [Characteristic for usage in camera mount]

A sliding film according to an embodiment of the present invention achieves the resistance value in a range of 10² to 10⁻⁴ [cm], in particular in range of 10⁻² to 10⁻⁴ [cm], further in range of 10⁻³ to 10⁻⁴ [Ωcm]. Accordingly, by using the sliding film, for example, in a mount (camera mount) for a camera capable of automatically controlling the lens such as an auto-focus camera, it is possible to realize transmission of electric signal between a lens section and a camera body of the camera, via the sliding film. Further, in a case that the sliding film is used in the mount of such a camera, a certain user attaches and detaches such as the lens section and/or a strobe frequently to and from (with respect to) the camera body in some cases, and such repeated frequent attachment/detachment causes the sliding film provided on a sliding portion of the mount to be exfoliated or peeled off in some cases. However, if such an exfoliation of the sliding film is occurred, it is not possible to realize the conduction between the lens section and the camera body via the sliding film as described above. Therefore, the sliding film is required to have also the wear resistance and the hardness. Further, the detachment/attachment of the lens section with respect to the camera body is performed manually by the user, and thus it is necessary that the attachment/detachment of the lens section with respect to the camera body via the sliding film is performed smoothly, thereby making it necessary to lower the dynamic friction of the sliding film. Thus, a sliding section or sliding portion used in a camera mount is required to have, at the same time, (i) low electrical resistivity, (ii) appropriate hardness (wear resistance); and (iii) low dynamic friction coefficient. However, when the metal dope amount (amount of metal dopant) is increased for the purpose of lowering the electrical resistivity, the hardness is lowered, which makes the film likely to be exfoliated. On the other hand, when the hardness of the film is increased too much, the dynamic friction coefficient also becomes high, which in turn lowers the slidability. For these reasons, the sliding film of the camera mount is required to satisfy the above-described three characteristics in a well-balance manner.

According to the experiments performed by the present inventor, it is appreciated that, in a case of using a sliding film mainly composed of tetrahedral amorphous carbon in the camera mount, the lens unit has a durability enduring attachment/detachment with respect to the camera body exceeding 5,000 times when the sliding film has the resistivity in a range of 10⁻² to 10⁻⁴ [Ωcm], the surface hardness in a range of 10 to 30 GPa, and the dynamic friction coefficient of less than 0.15. In particular, it is appreciated, through the examples (to be described later on) that in a case that Ti is used as the metal for doping and when the content of Ti is 1 to 25 at%, it is possible to satisfy the above-described resistivity, surface hardness and dynamic friction coefficient suitable for the camera mount.

### [Method for producing sliding film]

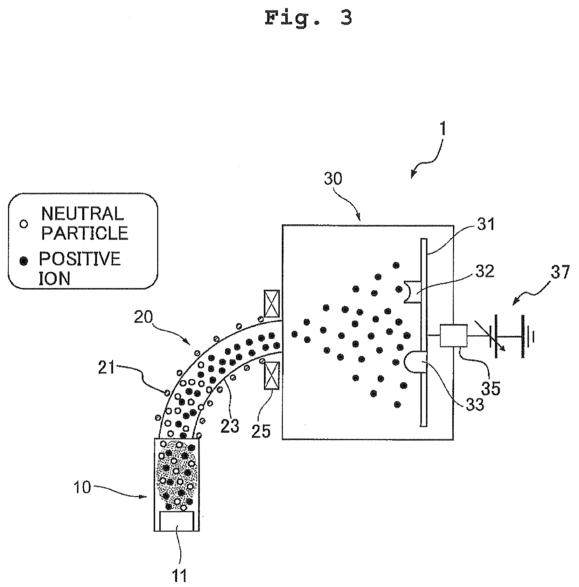

An explanation will be given about FCVA (Filtered Cathodic Vacuum Arc) method as an example of a film-forming method for forming a conductive sliding film on a substrate, and the schematic structure of a film-forming apparatus 1 for practicing the method, with reference to Fig. 3.

The film-forming apparatus 1 is mainly constructed of an arc plasma producing section 10, a filter section 20 and a film-forming chamber 30. The arc plasma producing section 10 and the film-forming chamber 30 are connected by the filter section 20 having a duct shape, and the pressure of the film-forming chamber 30 is set to have vacuum to an extent of about 10⁻⁵ [Torr] by an unillustrated vacuum device.

The arc plasma producing section 10 is provided with an anode (striker) and a cathode while sandwiching a target 11 therebetween, and the striker is brought into contact with the target 11 and then immediately is separated from the target 11 so as to produce arc discharge. In a case of forming a ta-C film, graphite is used as the target 11 and arc plasma (carbon plasma) is generated by the arc discharge. Neutral particle(s) and positively ionized carbon produced by the arc plasma fly in the filter section 20 toward the film-forming chamber 30. In order to produce a sliding film composed of a metal-doped ta-C film of the above-described embodiment, a target of graphite containing a metal but not containing hydrogen is used. The kinds of metal are exemplified by Ti, Ni, Cr, Al, Mg, Cu, Fe, Ag, Au, Pt, etc., as described above.

A duct 23 around which a double-bend electromagnetic coil 21 is wound and a coil 25 for scanning ion (ion-scanning coil 25) are provided on the filter section 20. The duct 23 is bent twice, in two directions perpendicular to each other, between the arc plasma producing section 10 and the film-forming chamber 30; and the double-bend electromagnetic coil 21 is wound around the outer circumference portion of the duct 23. Since the duct 23 has such a bend structure (double-bend structure), the particles flowing in the duct 23 collide with the inner wall surface thereof or flow along the wall surface thereof. By passing an electric current through the double-bend electromagnetic coil 21, the Lorentz force acts on the charged particles flowing inside the duct 23 to change a flying path of the charged particles.

Therefore, by optimizing electric power applied to the double-bend electromagnetic coil 21 with respect to the mass of ionized carbon, it is possible to accumulate charged particles which are lighter and/or heavier than the ionized carbon and neutral particles which are not bent by the Lorentz force on the inner wall of the duct 23 to be removed, and thereby to introduce only the ionized carbon to the film-forming chamber 30 with high efficiency. That is, the double-bend electromagnetic coil 21 and the duct 23 function as a narrow-band electromagnetic spatial filter through which only the target particles are passed with high efficiency.

The ion-scanning coil 25 scans a beam of ionized carbon which passes through the double-bend electromagnetic coil 21 and then enters into the film-forming chamber 30 as described above, and uniformly forms an a-C film (ta-C film, ta-C:M film) on a surface of each of substrates 32, 33 held by a holder 31. As the substrate, it is possible to use a material having an arbitrary shape and formed, for example, of an organic material such as a resin, etc.; an inorganic material such as a metal, ceramics, etc.; and the like. In a case of using the sliding film for the sliding portion of the camera mount, a plastic such as a resin or a metal such as brass is used.

The film-forming chamber 30 is provided with the holder 31 having a plate-shape and facing or opposite to the outlet of the filter section 20, and the substrates 32, 33 are set on a surface of the holder 31. The holder 31 is rotatable around the revolution axis thereof by a motor 35. Arbitrary bias can be set for the holder 31 by a power source 37. For example, by applying appropriate negative bias voltage in accordance with the desired composition ratio of a target ta-C film (ratio of sp³-C to sp²-C), it is possible to form a ta-C film with arbitrary composition ratio with high efficiency.

### [Member having sliding film]

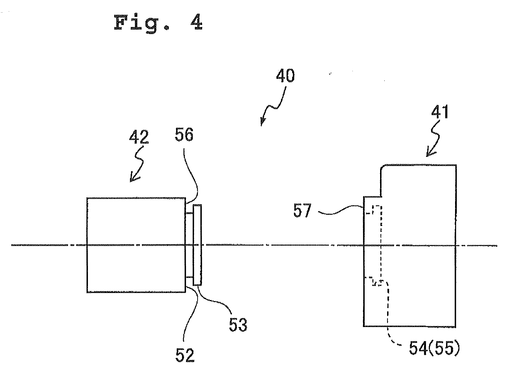

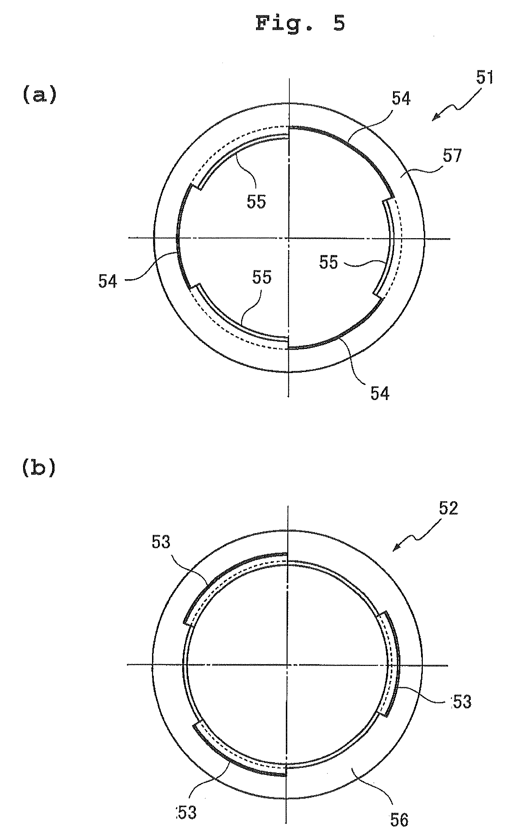

According to this embodiment, a member having the above-described sliding film is also provided. Although the sliding film of the embodiment can be used in members or parts (components) of variety of kinds of usage, in view of the high wear resistance, satisfactory slidability and conductivity (low resistivity) possessed by the sliding film, the sliding film is particularly suitable for a member which moves slidably relative to another member and/or a member which is connected to or joined to another member while moving slidably relative to the another member. Further, the sliding film of the embodiment is also suitable for a pair of members slidably moving relative to each other; and/or a member set and/or a member kit connected to or joined to each other while slidably moving relative to each other. In particular, the sliding film is suitable for a mount member, disposed on a side of a lens unit of a camera, in which the lens unit is attachable/detachable with respect to a camera body, and/or a mount member disposed on a side of the camera body of said camera. An explanation will be briefly made about these mount members with reference to Fig. 4, Fig. 5(a), and Fig. 5(b). A camera 40 includes a camera body 41 and an interchangeable lens 42 which are attachable/detachable with respect to each other. Each of the camera body 41 and the interchangeable lens 42 is provided with a bayonet-type mount (hereinafter, referred to as "mount" as appropriate). A claw portion 53 is provided for a male mount 52 of the interchangeable lens 42 to protrude therefrom. An insertion portion 54 into which the claw portion 53 of the male mount 52 is inserted and an engaging portion 55 with which the claw portion 53 is engaged are provided for a female mount 51 of the camera body 41. An engaging mechanism (not shown), which uses an elastic member etc., is provided for one of or both of the claw portion 53 and the engaging portion 55.

In order to attach the interchangeable lens 42 to the camera body 41, the claw portion 53 of the male mount 52 is inserted into the insertion portion 54 of the female mount 51; a contact surface 56 of the male mount 52 is brought in contact with a receiving surface 57 of the female mount 51; and the interchangeable lens 42 is rotated with respect to the camera body 41. In this situation, the contact surface 56 and the receiving surface 57 slidably move with respect to each other in a state that the contact surface 56 and the receiving surface 57 make contact with each other. Then, the interchangeable lens 42 is further rotated to engage the claw portion 53 of the male mount 52 with the engaging portion 55 of the female mount 51, and the attachment of the interchangeable lens 42 is completed. In this situation, a surface of the claw portion 53 and a surface of the engaging portion 55 slidably move with each other while making contact with each other. Further, in a case that the interchangeable lens 42 is detached or removed from the camera body 41, the processes described above are performed in a reversed order to the order described above. Therefore, the female mount 51 of the camera body 41 and the male mount 52 of the interchangeable lens 42 slidably move with respect to each other in a state that the female mount 51 and the male mount 52 make contact with each other every time when the interchangeable lens 42 is exchanged.

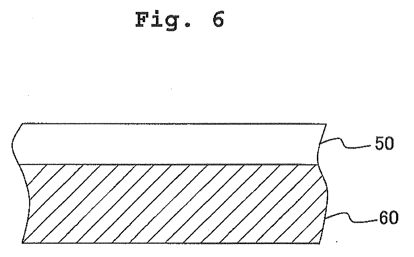

In the female mount 51 and the male mount 52, a sliding film 50 of the embodiment is formed on a surface of each of substrates 60 having the shapes of the female and male mounts 51, 52, respectively as shown in Fig. 6. Each of the substrates 60 is formed of a metal, a resin, ceramics, etc., and is typically formed of brass. The sliding film 50 may be a multi-layered film which is formed of a plurality of stacked film (coating) layers, which is formed as a film or coating on the surface of the substrate 60 with sufficient adhering force, by the FCVA method described above. In case of the multi-layered film, the uppermost layer of the multi-layered (stacked) film is the sliding film of the embodiment.

This embodiment also encompasses the camera body and/or the lens unit as shown in Figs. 4 and 5 (Figs. 5(a) and 5(b)). Note that the mount member disposed on the side of the lens unit and/or the mount member disposed on the side of the camera body are not limited to the bayonet-type, but may be a screw-in type or threaded type.

### [EXAMPLES]

In the following, the conductive sliding film of the present invention and a method for producing a member using the conductive sliding film of the present invention will be described. However, the present invention is not limited to the examples described below.

### [Examples 1 to 8]

The following shows Examples 1-8 by which conductive sliding films were formed by using the FCVA film-forming apparatus 1 as shown in Fig. 3. In each of the examples, a sintered graphite target containing 2.15 [at%] of Ti was used as the target 11 containing a metal element, and a ta-C:Ti film (titanium-doped tetrahedral amorphous carbon film) was formed on a surface of the substrate. Note that the examples used the sintered graphite target subjected to dehydration (dewatering treatment). In order to individually evaluate the resistivity, the hardness and elastic modulus, the film composition, the friction coefficient, the wear resistance, etc. of the ta-C:Ti film (to be described later on), the formation of ta-C:Ti film was performed a plurality of times, under a same condition except for selectively using the different kinds of substrate, respectively. Specifically, a SiO₂ glass substrate was used to measure the resistivity, a brass camera mount was used to evaluate the wear resistance, and Si substrates were used for measuring/evaluating the remaining characteristics other than the resistivity and the wear resistance.

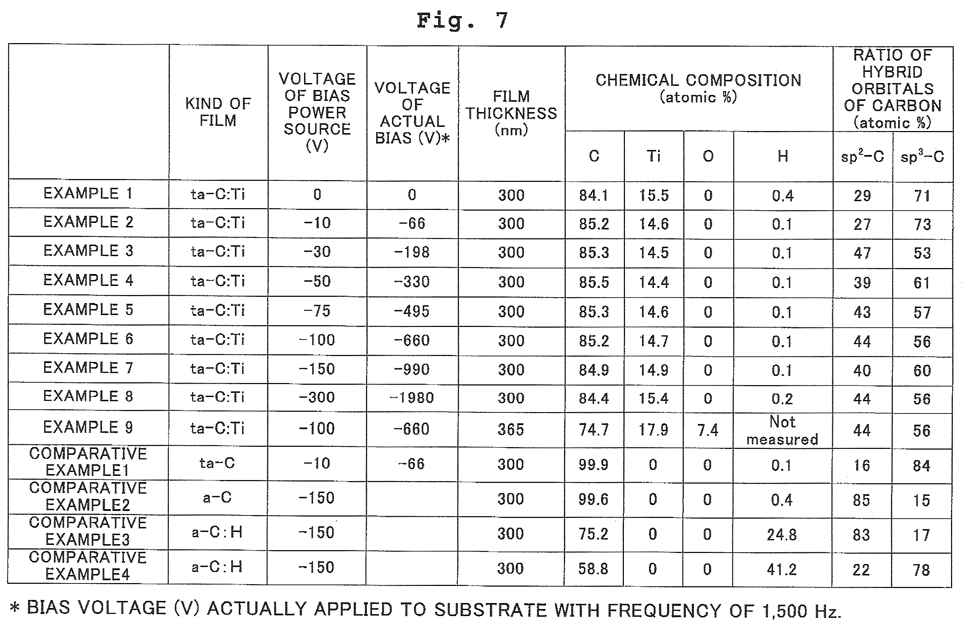

The typical operating conditions for the FCVA film-forming apparatus 1 (see Fig. 3) during the film-formation of ta-C:Ti film were as follows: Arc current of a vacuum arc power source (power source on a side of the cathode) in the arc plasma producing section 10 was 50A; current (filter current) of the double-bend electromagnetic coil 21 in the filter section 20 was 13A; current (anode current) of the power source on a side of the anode in the arc plasma producing section 10 was 8A; and voltage (duct voltage) of the ion-scanning coil 25 was 0.2 V. With respect to the voltage of the bias power source and the bias voltage (actual bias voltage) actually applied to the substrate with a frequency 1,500 Hz, Examples 1-8 used the values as those shown in Fig. 7, respectively. Note that the electric discharge for 600 seconds was repeated for five times.

With respect to the film formed on the Si substrate as described above in the respective examples, measurement was performed with the Rutherford backscattering spectrometry method to obtain the content amounts of carbon (C), titanium (Ti), oxygen (O) and hydrogen (H) contained in the film. The measurement results are shown in the table of Fig. 7. In the films of Examples 1 to 8, the hydrogen content was 0.1 to 0.4 [at%]. However, considering that the target 11 did not contain hydrogen and the target 11 was subjected to the dewatering treatment, this is considered as hydrogen originated from the measurement device (background).

Next, regarding the obtained films, the ratio of sp²-C bond (hybrid orbital) and sp³-C bond (hybrid orbital) of the carbon contained in the film was analyzed with X-ray photoelectron spectroscopy method. The analysis results are shown in the table of Fig. 7. It is appreciated that in the films of Examples 1 to 8, the ratio of the sp³-C bond is 53 at% to 73 at% with respect to the entire carbon bond (sp²-C + sp³-C), and that the films obtained in Examples 1 to 8 are tetrahedral amorphous carbon.

### [Example 9]

Film-formation was performed under the same condition as that of Example 1, except that a sintered graphite target containing 2.15 [at%] of Ti without any dewatering treatment was used as the target 11 containing the metal element, and that the operating conditions of the FCVA film-forming apparatus 1 were changed to the values shown in Fig. 7. A film having a thickness (film thickness) of 365 [nm] was formed on the substrate with a film-forming rate of 0.12 [nm/s].

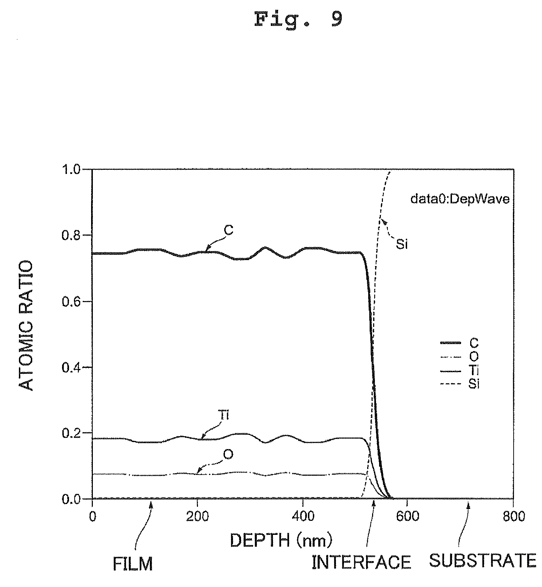

With respect to the film obtained in Example 9, the components composing the film were analyzed with the Rutherford backscattering spectrometry method, in a similar manner as in Example 1. The analysis result is shown in the table of Fig. 7. Note that for the film obtained in Example 9, no measurement regarding hydrogen could not be performed because of experimental constrains or reasons. Fig. 9 shows the chemical composition in the depth direction of the film obtained in Example 9. In the graph of Fig. 9, the horizontal axis is the depth in the film thickness direction (thickness direction) from a surface of the film, and the vertical axis is the atomic ratio (composition). From the measurement result, it is appreciated that the carbon C, titanium Ti, and oxygen O contained in the film are substantially constant with respect to the composition ratio of the respective elements in the depth direction. The reason why oxygen is contained in the film obtained in Example 9 is considered that the used target was not subjected to any dewatering treatment.

Next, with respect to the obtained film, the ratio of the sp²-C and sp³-C bonds of the carbon contained in the film was analyzed with the X-ray photoelectron spectroscopy, in a similar manner as in Example 1. The analysis result is shown in the table of Fig. 7. Considering that the ratio of the sp³-C bond is 56 at% with respect to the entire carbon bond (sp²-C + sp³-C), it is considered that tetrahedral amorphous carbon is probably formed in Example 9.

### [Comparative Example 1]

A film having a thickness of 300 nm was formed in a similar manner as in Example 1, except that a sintered graphite target not containing Ti was used as the target 11 containing the metal element and that the operating condition (bias voltage) of the FCVA film-forming apparatus 1 was changed to the value shown in Fig. 7.

The film formed on a Si substrate as described above was analyzed with the Rutherford backscattering spectrometry method, and it is appreciated that 99.9 at% of carbon was contained in the film (see the table of Fig. 7).

Next, with respect to the obtained film, the ratio of the sp²-C and sp³-C bonds of the carbon contained in the film was analyzed with the X-ray photoelectron spectroscopy. As shown in the table of Fig. 7, since the ratio of the sp³-C bond is 84 at% with respect to the entire carbon bond (sp²-C + sp³-C), the film obtained in Comparative Example 1 is tetrahedral amorphous carbon (ta-C). Note that the composition of the film obtained in Comparative Example 1 appears on the line connecting the sp²-C and sp³-C of the phase diagram of Fig. 2.

### [Comparative Example 2]

Film-formation was performed with the ion plating method by using benzene vapor (C₆H₆) as the raw material to form an amorphous carbon film having a thickness of 300 nm on a substrate heated to 400 degrees Celsius. In order to individually evaluate the hardness and elastic modulus, the film composition, the friction coefficient, etc., of the film (to be described later on), the film-formation was performed a plurality of times, under a same condition except for selectively using the different kinds of substrate, respectively, in a similar manner as in Example 1.

The film formed on a Si substrate as described above in Comparative Example 2 was analyzed with the Rutherford backscattering spectrometry method, and it is appreciated that the film contained 99.6 at% of carbon and 0.4 at% of hydrogen (see the table of Fig. 7).

Next, with respect to the obtained film, the ratio of the sp²-C and sp³-C bonds of the carbon contained in the film was analyzed with the infrared spectroscopy.

As shown in the table of Fig. 7, since the ratio of the sp²-C bond is 85.2 at% with respect to the entire carbon bond (sp²-C + sp³-C), it is appreciated that the film obtained in Comparative Example 2 is amorphous carbon (a-C). Note that the composition of the film obtained in Comparative Example 2 is indicated as "IP a-C" in the phase diagram of Fig. 2.

### [Comparative Example 3]

Film-formation was performed by using the ion plating method in a similar manner as Comparative Example 2, except that the temperature of the substrate was changed to 200 degrees Celsius. The film formed on a Si substrate was measured by the Rutherford backscattering spectrometry method, and the film contained 75.2 at% of carbon and 24.8 at% of hydrogen. The ratio of the sp²-C and sp³-C bonds of the carbon contained in the film was analyzed with the X-ray photoelectron spectroscopy. As shown in the table of Fig. 7, the ratio of the sp²-C bond is 83 at% with respect to the entire carbon bond (sp²-C + sp³-C), and further the ratio of hydrogen contained in the film was 24.8 at%; and thus it is appreciated that the film obtained in Comparative Example 3 is a hydrogenated amorphous carbon (a-C:H).

### [Comparative Example 4]

Film-formation was performed with the plasma-enhanced CVD method using methane gas (CH₄) as the raw material to form a carbon film having a thickness of 300 nm on a substrate heated to 100 degrees Celsius. In order to individually evaluate the hardness and elastic modulus, the film composition, the friction coefficient, etc. of the film (to be described later on), the film-formation was performed a plurality of times, under a same condition except for selectively using the different kinds of substrate, respectively, in a similar manner as in Example 1.

The film formed on a Si substrate as described above was measured by the Rutherford backscattering spectrometry method, and it is appreciated that the film contained 58.8 at% of carbon and 41.2 at% of hydrogen (see the table in Fig. 7).

Next, the ratio of the sp²-C and sp³-C bonds of the carbon contained in the film was analyzed with the X-ray photoelectron spectroscopy. As shown in the table of Fig. 7, the ratio of the sp³-C bond is 78 at% with respect to the entire carbon bond (sp²-C + sp³-C); and thus it is appreciated that the film obtained in Comparative Example 4 is a hydrogenated amorphous carbon (a-C:H). Note that the composition of the film obtained in Comparative Example 4 is indicated as "PECVD a-C:H" in the phase diagram of Fig. 2.

With respect to the films obtained in Examples 1 to 9 and Comparative Examples 1 to 4, the resistivity, the hardness and elastic modulus, the friction coefficient, etc. as the physical properties of the films were measured as follows.

### (1) Resistivity

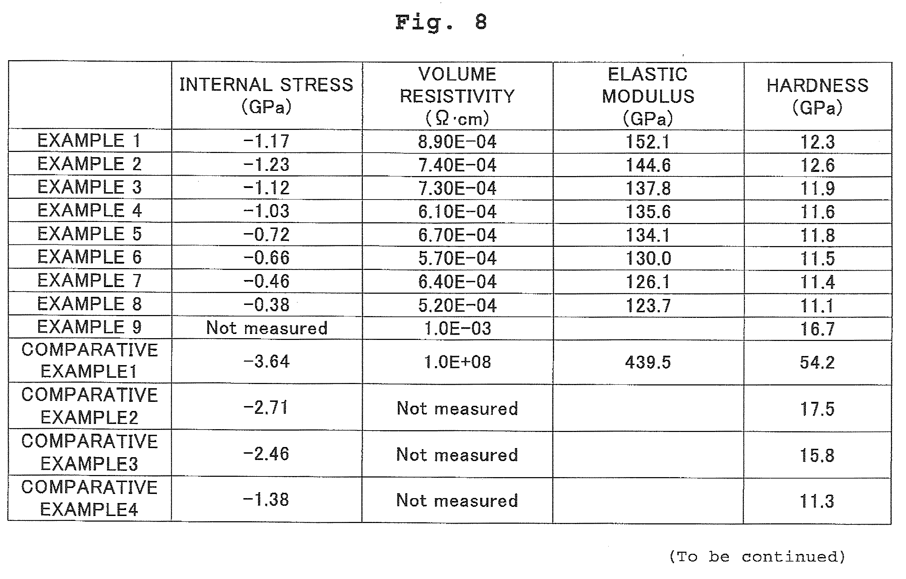

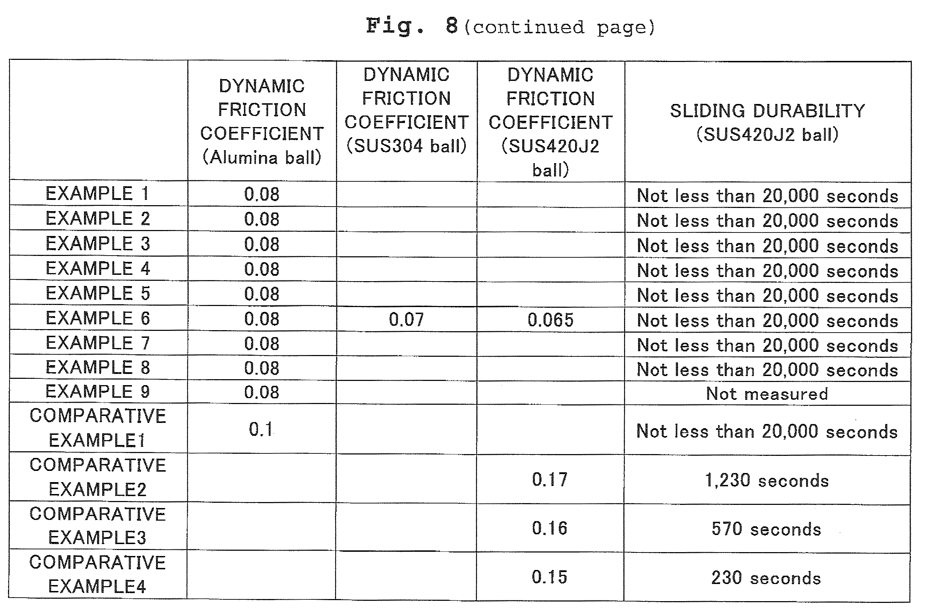

The resistivity (volume resistivity) of ta-C:Ti films, etc. formed on a SiO₂ glass substrate. was measured by the 4-point probe method. The measured values are shown in the table of Fig. 8. The resistivity of the film obtained in each of Examples 1 to 9 was 1x10⁻⁴ to 1x10⁻³ [Ωcm]. The ta-C film (Comparative Example 1) which was not doped with a metal element had the resistivity of a high value that was the order of 1x10⁸ [Ωcm]. From these results, it is understood that a ta-C:M film having a satisfactory conductivity is formed by performing film-formation with the FCVA method by using a graphite target containing a metal or metal carbide as the raw material.

### (2) Hardness and Elastic modulus

The hardness and elastic modulus were measured regarding each of the ta-C:Ti films formed on the Si substrates with the nanoindentation method at a plurality of sampling positions. The measured hardness and elastic modulus of the film of each of Examples 1 to 9 and Comparative Examples 1 to 4 are shown in the table of Fig. 8. It is appreciated that the hardness of the film obtained in each of Examples 1 to 8 was in a range of 11 to 13 [GPa], and that the elasticity of the film obtained in each of Examples 1 to 8 was in a range of 120 to 153 [GPa]. Note that for a reference purpose, the hardness of a metal chrome film which is provided on the substrate made of brass, and which is conventionally employed, is approximately in an extent of 8 [GPa]. Accordingly, it is confirmed that the ta-C:Ti film, formed by the producing method of the aspect of the present invention, has a high hardness remarkably higher than that of the conventional metal chrome film, and the films of Examples 1 to 8 have a high hardness which is about 1.5 times that of the conventional metal chrome film.

### (3) Friction coefficient

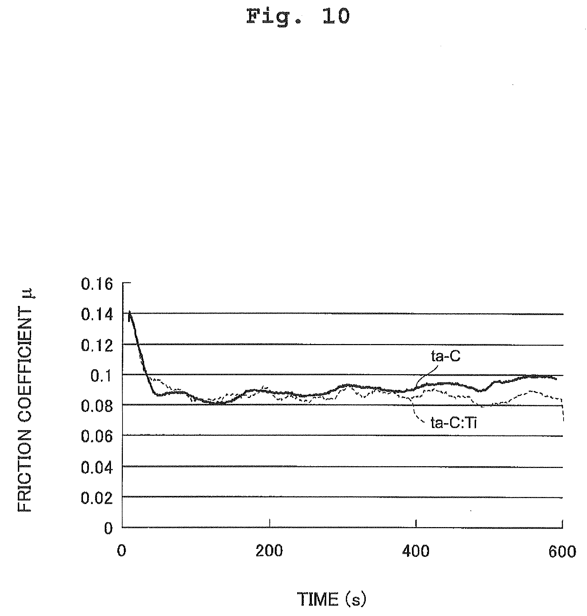

Next, with respect to the film formed on the Si substrate in each of Examples 1 to 9 and Comparative Examples 1 to 4, the wear characteristic (abrasion characteristic) was measured by the ball-on-disk method. An alumina ball was used for the measurement with the following conditions of load: 200 [gf]; radius of rotation: 2[mm]; and rotation speed: 100 [rpm]. With respect to the films of Examples 1 to 9 and Comparative Examples 1 to 4, the average value of the dynamic friction coefficients with respect to the time was measured and shown in the table of Fig. 8. From the measurement results, it is appreciated that each of the films of Examples 1 to 9 has the dynamic friction coefficient of 0.08 (less than 0.1); that the ta-C:Ti films of the examples each have a friction coefficient which is further lower than that of the ta-C film, namely a satisfactory slidability. Note that the graph of Fig. 10 shows the measurement results of the dynamic friction coefficients regarding the films of Example 9 and Comparative Example 1. In the graph of Fig. 10, the horizontal axis indicates the time, and the vertical axis indicates the dynamic friction coefficient. With respect to the films obtained in Comparative Examples 2 to 4, the average values of the dynamic friction coefficients was obtained by using a SUS420J2 ball, in a similar manner as described above. For the comparison purpose, the average values of the dynamic friction coefficients were measured with respect to the film of Example 6 by using a SUS304 ball and the SUS420J2 ball, in addition to the alumina ball, in a similar manner as described above; and the average values were 0.07 and 0.065, respectively (the dynamic friction coefficient obtained by using the SUS420J2 ball is smaller than the dynamic friction coefficient obtained by using the alumina ball). The phase diagram of Fig. 2 indicates the range of dynamic friction coefficients of the films obtained in Comparative Examples 1 to 4 and of the tetrahedral amorphous carbon films of various compositions. It is appreciated that the amorphous carbons not containing hydrogen (a-C or ta-C) have a dynamic friction coefficient smaller than that of the hydrogenated amorphous carbons (a-C:H); and that among the amorphous carbons not containing hydrogen, tetrahedral amorphous carbon has a small dynamic friction coefficient, and as the ratio of sp³-C bond is increased, the dynamic friction coefficient becomes smaller.

### (4) Sliding durability

With respect to the film formed on the Si substrate in each of Examples 1 to 9 and Comparative Examples 1 to 4, the sliding durability was measured with the ball-on-disk method. A SUS420J2 ball was used with the following conditions of load: 1,000 [gf]; radius of rotation: 2[mm]; and rotation speed: 100 [rpm], and the time until occurrence of film exfoliation was measured. The results are shown in the table of Fig. 8. The time until occurrence of film exfoliation was not less than 20,000 seconds for the sliding films produced with the FCVA method in Examples 1 to 9 and Comparative Example 1; whereas the time until occurrence of film exfoliation was less than 1,300 seconds for the films produced by the other methods different from the FCVA method in Comparative Examples 2 to 4. In particular, the sliding durability of the hydrogenated amorphous carbon film of each of Comparative Examples 3 and 4 was inferior.

### (5) Internal stress

The internal stress was measured regarding the films obtained in the examples and the comparative examples. The internal stress was obtained by measuring the curvature radiuses of each of the substrates with a stylus type profilometer before and after the film formation on each of the substrates, and then calculating based on the Young modulus, etc. of each of the substrates. The results are shown in the table of Fig. 8. In the table, the signs of internal stresses being negative means that the stresses are compressive stress. Since the ta-C:Ti films obtained in Examples 1 to 8 have a smaller compressive stress as compared with the ta-C film obtained in Comparative Example 1, the ta-C:Ti films obtained in Examples 1 to 8 are more suitable for the application for which mechanical durability is required.

### (6) Heat resistance

With respect to the films obtained in Examples 1 to 9 and Comparative Examples 1 to 4, the heat resistance was evaluated with the thermal desorption method. In each of Examples 1 to 9 and Comparative Example 1, the heat resistance was high that was 850 degrees Celsius due to the structure of tetrahedral amorphous carbon. On the other hand, in each of Comparative Examples 2 to 4, the heat-resistances were less than 700 degrees Celsius, less than 400 degrees Celsius, and less than 300 degrees Celsius, respectively.

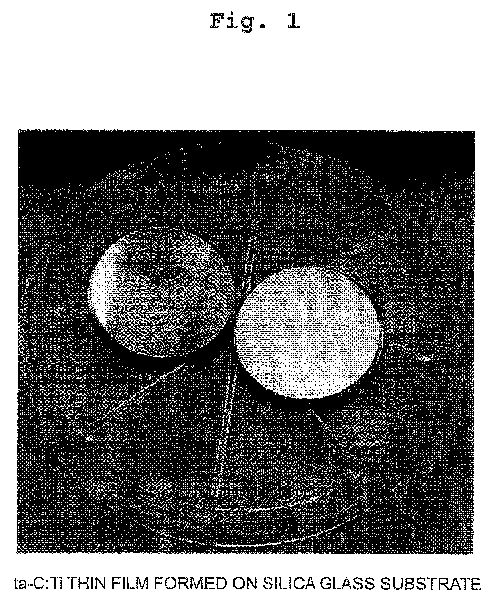

Fig. 1 shows an external appearance photograph of the ta-C:Ti film obtained in Example 9. As supported by the high resistivity that is 1x10⁻³ [Ωcm], the ta-C:Ti film obtained in Example 9 was a highly reflective film with a metallic luster close or similar to a metallic thin film due to free electrons. The films of Examples 1 to 8 also had a similar metallic luster. On the other hand, the ta-C film obtained in Comparative Example 1 is transparent and is acknowledged to have an interference color corresponding to the film thickness.

### [Examples 10 to 14]

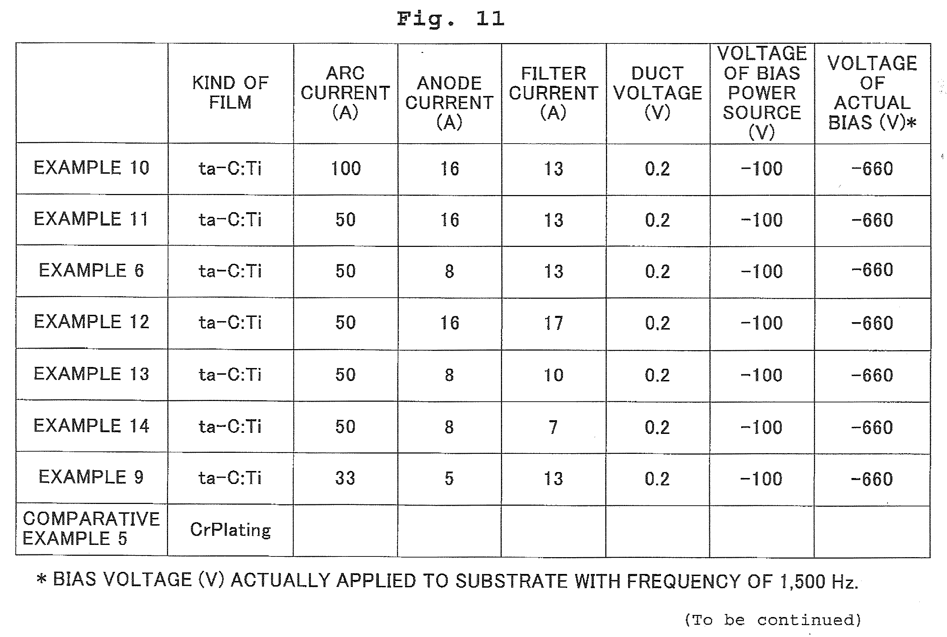

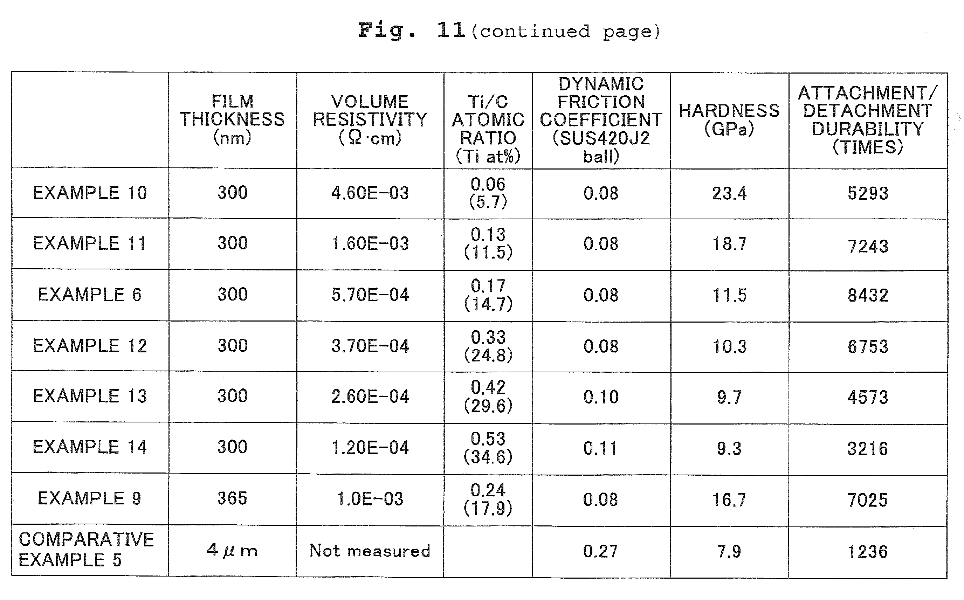

In Examples 10 to 14, ta-C:Ti films having different Ti/C atomic ratios were formed in a similar manner as in Example 1, except that the operating conditions of the FCVA apparatus were made to have values as shown in the table of Fig. 11. The Ti/C atomic ratios of the obtained films are shown in the table of Fig. 11. Note that the table of Fig. 11 also shows the atomic ratio (at%) of Ti in the films. Further, the volume resistivity, the hardness and the dynamic friction coefficient of the obtained ta-C:Ti films were also measured in a similar manner as in Examples 1 to 9, and the measurement results are shown in the table of Fig. 11. Note that for a reference purpose, the respective physical properties of the films obtained in Examples 6 and 9 are also shown in the table of Fig. 11.

### [Attachment/Detachment durability test (Evaluation of wear resistance)]

Next, the performance as the sliding film for camera bayonet was evaluated in the following manner. Under the operating conditions of the FCVA apparatus in Examples 6, 9 and 10-14, a ta-C:Ti film was formed (applied) to have a thickness of 2 microns on each of a brass mount on the lens side and on a mount on the camera body side. Further as a comparative example, a metallic Cr film was formed (applied) to have a thickness of 4 microns on each of a brass mount on the lens side and on a mount on the camera body side with the hexavalent chromium plating method (Comparative Example 5). The actual device test was performed by repeatedly attaching and detaching the ta-C:Ti film and metallic Cr film with respect to the camera body and the lens unit (exchange lens); and the number of attachment/detachment times until the film was completely exfoliated (peeled off) and the substrate was exposed were counted. The results are shown in the table of Fig. 11. From the results, it is appreciated that the ta-C:Ti films of Examples 6, 9 and 10-14 have a much superior wear resistance as compared with the conventional metallic Cr film of Comparative Example 5. In particular, it is appreciated that when the ta-C:Ti films of the examples have the hardness of 10 to 30 GPa and the dynamic friction coefficient of less than 0.15, the ta-C:Ti films have the durability enduring attachment/detachment of the lens unit with respect to the camera body exceeding 5,000 times (Examples 6 and 10-12). Since the conductivity is required for the lens unit and the body unit of camera, the dope amount of the metal element can be increased in order to increase the conductivity (to lower the resistivity). However, as appreciated from the table of Fig. 11, when the dope amount of Ti is increased, the volume resistivity is lowered but the hardness is lowered and the dynamic friction coefficient is increased. For this reason, it is appreciated that the conductivity, hardness and dynamic friction coefficient need to be appropriately balanced. Further, it is appreciated that as the sliding film for the camera mount for which such characteristics are required, and in a case that the doped metal is Ti, the excellent wear resistance is realized while maintaining appropriate conductivity, by making the content of Ti to be not more than 25 at%.

As shown by the evaluation results described above, the ta-C:Ti films of the examples have the wear resistance based on the high hardness similar to that of a ta-C film, have the satisfactory slidability based on the low friction coefficient, further have the satisfactory conductivity capable of transmitting electric signals as well, and are provided with the metallic luster suitably ensuring external appearance quality. Namely, there is successfully realized a new conductive sliding film (thin film which is conductive and with high hardness and low friction coefficient) suitably ensuring the above characteristics, at the same time, that have been conventionally considered as being mutually contradicting and hardly achievable at the same time.

A member having such a conductive sliding film formed on a surface thereof has a high external appearance quality realized by the metallic luster, and is capable of maintaining the external appearance quality for a long period of time owing to the high wear resistance. In addition, a connection member, which has the conductive sliding film formed on a contact surface thereof and which is movable slidably on and relative to a contact surface of another member and is connectable to the contact surface of the another member, is easily subjected to the attachment/detachment operation due to the satisfactory slidability, and it is possible to suppress the connection member from being worn and/or damaged due to the high wear resistance, even if the connection member is subjected to the repeated attachment/detachment accompanying the relative sliding movement. According to such a configuration that the conductive sliding film is formed on a surface of a substrate made of a metal material, it is possible to easily form a connection member having a complex structure and/or requiring high precision, while making it possible to obtain a connection member having a high-hardness connection surface which cannot be realized with a metal film (metal coating film). On the other hand, according to such a configuration that the conductive sliding film is formed on a surface of a substrate made of a resin material, it is possible to easily and inexpensively provide a connection member having a connection surface which has a high hardness and conductivity that cannot be realized with a resin part or component.

The configuration, wherein the connection member is formed of a first connection member and a second connection member which slidably move relative to each other and which are connected detachably with respect to each other; and the first and second connection members are connected mechanically and electrically when the first and second connection members slidably move relative to each other and engaged and connected to each other, can enjoy great effect by suitably using the properties such as the high hardness, low friction coefficient and conductivity realized by the conductive sliding film of the examples described above. For example, a mount member provided on the body side, a mount member provided on the lens side, a hot shoe (bracket, etc.) to and from which a flash, etc. is engaged and disengaged, etc. in a camera system configured so that a lens unit is detachable or removable and interchangeable with respect to a camera body, are representative examples to which the conductive sliding films of the examples are most suitable, including the external appearance quality.

The conductive sliding film of the embodiments can be practiced by the FCVA method that is a dry process without using any chemical substance hazardous for the human body in the film-forming process. Therefore, the conductive sliding film can be produced without damaging the environment. In particular, according to the FCVA method, it is possible to form a conductive sliding film having the predetermined composition in which the resistivity is in the range of 10² to 10⁻⁴ [Ωcm] and the surface hardness is in the range of 10 to 30 [GPa], on a variety of kinds of substrates such as those formed of a metal material, resin material, inorganic material, etc. with high efficiency. In particular, it is possible to form a conductive sliding film provided with such characteristics that the resistivity is in the range of 10⁻² to 10⁻⁴ [Ωcm], the surface hardness is in the range of 10 to 30 [GPa] and the dynamic friction coefficient is less than 0.15, which is suitable for a mount for a camera.

The foregoing explanation has been made regarding preferable embodiments of the present invention. However, the present invention is not limited to these embodiments. For example, although titanium is described as an example of a metal dope element for the ta-C:M, it is sufficient that the metal dope element serves to impart the conductivity to the film based on ta-C, as will be understood by a person skilled in the art from the foregoing explanation; and the dope metal may be other metal element such as, for example, Ni, Cr, Al, Mg, Cu, Fe, Ag, Au, Pt, etc.

Further, although a mount for a system camera in which a lens unit is attachable/detachable with respect to the camera body (still camera such as silver halide camera or digital camera, video camera, etc.) is exemplified as a specific application example of the connection member movable slidably relative to other member, the present invention is not limited to such an aspect, and is applicable to a wide variety of applications. The applications are exemplified, for example, by an electrical connector, a slip-ring, a connection device, a packaging (exterior) material for a device such as a camera, mobile phone, etc., and it is possible to obtain a similar effect also in these applications.

### [REFERENCE SIGNS LIST]

- 1:: film-forming apparatus
- 10:: arc plasma producing section
- 11:: target
- 20:: filter section
- 21:: double-bend electromagnetic coil
- 23:: duct
- 25:: ion-scanning coil
- 30:: film-forming chamber
- 31:: holder
- 32, 33:: substrate
- 40:: camera
- 41:: camera body
- 42:: interchangeable lens
- 50:: conductive sliding film
- 51:: female mount
- 52:: male mount

## Claims

1. A mount member provided on a side of a body and/or a lens of a camera system configured so that a lens unit is detachable and interchangeable with respect to a camera body, the mount member comprising:
a substrate; and
a conductive sliding film which is formed on the substrate;
wherein the conductive sliding film is formed of tetrahedral amorphous carbon doped with a metal and which has resistivity of 10⁻² to 10⁻⁴ [Ωcm], surface hardness of 10 to 30 [GPa] and dynamic friction coefficient of less than 0.15.

2. The mount member according to claim 1, wherein the metal is titanium, and a content of the titanium is 1 to 33 [at%].

3. The mount member according to claim 2, wherein the content of the titanium is 1 to 20 [at%].

4. The mount member according to claim 1, wherein the conductive sliding film contains not more than 0.3 at% hydrogen.

5. Use of a sliding film in a mount member used for a camera system and provided on a side of a body and/or a lens of the camera system configured so that a lens unit is detachable and interchangeable with respect to a camera body, the mount member comprising:
a substrate; and
a conductive sliding film which is formed on the substrate;
wherein the conductive sliding film is formed of tetrahedral amorphous carbon doped with a metal and which has resistivity of 10⁻² to 10⁻⁴ [Ωcm], surface hardness of 10 to 30 [GPa] and dynamic friction coefficient of less than 0.15.

6. A camera body comprising the mount member as defined in any one of the claims 1 to 4 provided thereon.

7. A lens unit comprising the mount member as defined in any one of the claims 1 to 4 provided thereon.

## Patentansprüche

1. Befestigungsteil, vorgesehen auf einer Seite eines Körpers und/oder einer Linse eines Kamerasystems, so konfiguriert, dass eine Linseneinheit ablösbar und austauschbar in Bezug auf einen Kamerakörper ist, wobei das Befestigungsteil umfasst:
ein Substrat; und
einen leitenden Gleitfilm, der auf dem Substrat gebildet ist,
worin der leitende Gleitfilm aus tetraedrischem amorphem Kohlenstoff, dotiert mit einem Metall, gebildet ist und einen Widerstandswert von 10⁻² bis 10⁻⁴ [Ωcm], eine Oberflächenhärte von 10 bis 30 [GPa] und dynamischen Friktionskoeffizienten von weniger als 0,15 hat.

2. Befestigungsteil nach Anspruch 1 worin das Metall Titan ist und ein Titangehalt 1 bis 33 [at%] ist.

3. Befestigungsteil nach Anspruch 2, worin der Titangehalt 1 bis 20 [at%] ist.

4. Befestigungsteil nach Anspruch 1, worin der leitende Gleitfilm nicht mehr als 0,3 at% Wasserstoff enthält.

5. Verwendung eines Gleitfilmes in einem Befestigungsteil, das für ein Kamerasystem verwendet wird und auf einer Seite eines Körpers und/oder einer Linse des Kamerasystems vorgesehen ist, das so konfiguriert ist, dass eine Linseneinheit ablösbar und austauschbar mit Bezug auf einen Kamerakörper ist, wobei das Befestigungsteil umfasst:
ein Substrat; und
einen leitenden Gleitfilm, der auf dem Substrat gebildet ist,
worin der leitende Gleitfilm aus tetraedrischem amorphem Kohlenstoff, dotiert mit einem Metall, gebildet ist und einen Widerstandswert von 10⁻² bis 10⁻⁴ [Ωcm], eine Oberflächenhärte von 10 bis 30 [GPa] und dynamischen Friktionskoeffizienten von weniger als 0,15 hat.

6. Kamerakörper, umfassend das Befestigungsteil wie in einem der Ansprüche 1 bis 4 definiert, das darauf vorgesehen ist.

7. Linseneinheit, umfassend das Befestigungsteil wie in einem der Ansprüche 1 bis 4 definiert, das darauf vorgesehen ist.

## Revendications

1. Elément de montage prévu sur un côté d'un corps et/ou d'une lentille d'un système de caméra configuré de sorte qu'une unité de lentille soit détachable et interchangeable par rapport à un corps de caméra, l'élément de support comprenant :
un substrat ; et
un film coulissant conducteur qui est formé sur le substrat ;
dans lequel le film coulissant conducteur est formé de carbone amorphe tétraédrique dopé avec un métal et qui possède une résistivité de 10⁻² à 10⁻⁴ [Ωcm], une dureté de surface de 10 à 30 [GPa] et un coefficient de friction dynamique de moins de 0,15.

2. Elément de montage selon la revendication 1, dans lequel le métal est du titane et la teneur en titane est de 1 à 33 [% atomique].

3. Elément de montage selon la revendication 2, dans lequel la teneur en titane est de 1 à 20 [% atomique].

4. Elément de montage selon la revendication 1, dans lequel le film coulissant conducteur ne contient pas plus de 0,3 % atomique d'hydrogène.

5. Utilisation d'un film coulissant dans un élément de montage utilisé pour un système de caméra et prévu sur un côté d'un corps et/ou d'une lentille du système de caméra configuré de sorte qu'une unité de lentille soit détachable et interchangeable par rapport à un corps de caméra, l'élément de support comprenant :
un substrat ; et
un film coulissant conducteur qui est formé sur le substrat ;
dans lequel le film coulissant conducteur est formé de carbone amorphe tétraédrique dopé avec un métal et qui possède une résistivité de 10⁻² à 10⁻⁴ [Ωcm], une dureté de surface de 10 à 30 [GPa] et un coefficient de friction dynamique de moins de 0,15.

6. Corps de caméra comprenant l'élément de montage selon l'une quelconque des revendications 1 à 4 qui y est monté .

7. Unité de lentille comprenant l'élément de montage selon l'une quelconque des revendications 1 à 4 qui y est monté.
